(19) **Europäisches Patentamt / European Patent Office / Office européen des brevets**

(11) **EP 4 593 293 A1**

(12) # EUROPEAN PATENT APPLICATION
published in accordance with Art. 153(4) EPC

(43) Date of publication:
**30.07.2025  Bulletin 2025/31**

(21) Application number: **24824382.6**

(22) Date of filing: **07.11.2024**

(51) International Patent Classification (IPC):
***H03M 1/12*** *(2006.01)*

(86) International application number:
**PCT/CN2024/130368**

(87) International publication number:
**WO 2025/118905 (12.06.2025 Gazette 2025/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.12.2023  CN 202311686477**

(71) Applicants:
  • **State Grid Zhejiang Tongxiang Electric Power
    Supply Company
    Jiaxing, Zhejiang 314500 (CN)**
  • **State Grid Zhejiang Jiaxing Electric Power
    Supply
    Company
    Jiaxing, Zhejiang 314001 (CN)**
  • **XJ Electric Co., Ltd
    Xuchang, Henan 461000 (CN)**
  • **XJ Group Corporation
    Xuchang, Henan 461000 (CN)**

(72) Inventors:
  • **JIANG, Wendong
    Jiaxing
    Zhejiang 314500 (CN)**
  • **YUAN, Liang
    Xuchang
    Henan 461000 (CN)**
  • **WANG, Guangzeng
    Jiaxing
    Zhejiang 314500 (CN)**

  • **LI, Can
    Xuchang
    Henan 461000 (CN)**
  • **FAN, Caiyun
    Xuchang
    Henan 461000 (CN)**
  • **XU, Hong
    Jiaxing
    Zhejiang 314500 (CN)**
  • **LI, Pei
    Jiaxing
    Zhejiang 314500 (CN)**
  • **ZHENG, Tuofu
    Xuchang
    Henan 461000 (CN)**
  • **ZHOU, Min
    Jiaxing
    Zhejiang 314001 (CN)**
  • **WEI, Zemin
    Jiaxing
    Zhejiang 314001 (CN)**
  • **HUANG, Hongyang
    Jiaxing
    Zhejiang 314500 (CN)**
  • **YAO, Haiqiang
    Jiaxing
    Zhejiang 314500 (CN)**
  • **ZHAO, Yuheng
    Xuchang
    Henan 461000 (CN)**

(74) Representative: **Elzaburu S.L.P.
    Paseo de la Castellana 259C
    Torre de Cristal, planta 28
    28046 Madrid (ES)**

(54) **MULTI-CHANNEL ELECTRONIC COLLECTION UNIT CONNECTED TO WIDEBAND VOLTAGE TRANSFORMER**

(57)  The present invention belongs to the technical field of voltage transformer measurement, and in particular to a multi-channel electronic acquisition unit connected to a wide-band voltage transformer. To resolve a problem that a signal is output by the electronic acquisition unit in a single mode in the prior art, and an output signal communicates with only a merging unit, which is not suitable for wide-band voltage measurement, in the present invention, a conditioning loop in the electronic acquisition unit is improved, so that data collected by the voltage transformer is output as at least two analog

**(Cont. next page)**

signals after conditioned by the conditioning loop. At least one analog signal is converted into a digital signal, the digital signal is output from the electronic acquisition unit, and at least one of remaining analog signals is directly output from the electronic acquisition unit, to implement acquisition of high-order voltage harmonics and transmission of analog and digital signals, ensuring the safe and stable operation of a power grid, providing accurate measurement of a power-frequency signal, a harmonic signal, and a transient signal, and promoting the upgrading of the voltage transformer.

FIG. 3

## Description

## FIELD OF TECHNOLOGY

The present invention belongs to the technical field of voltage transformer measurement, and in particular to a multi-channel electronic acquisition unit connected to a wide-band voltage transformer.

## BACKGROUND

In a smart substation, there are two application scenarios in which an acquisition electronic circuit is used to connect a voltage transformer signal:

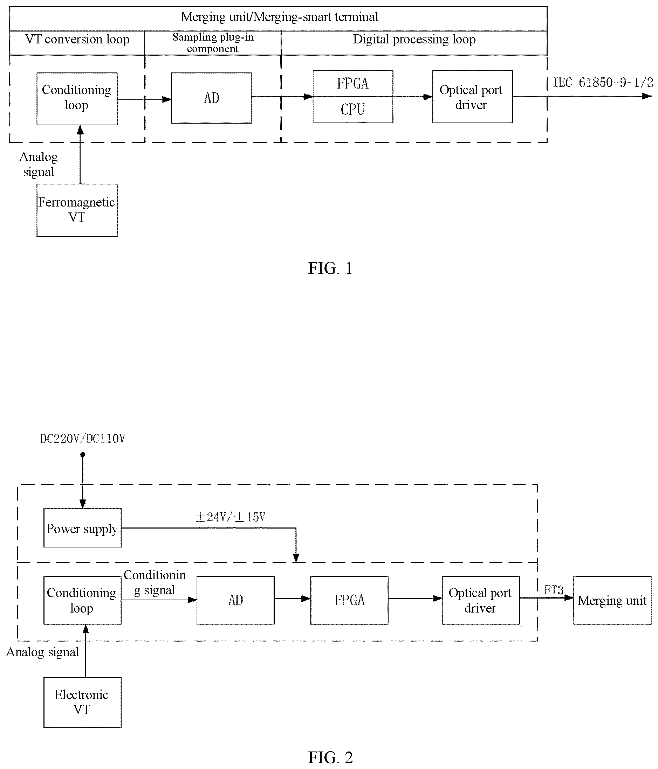

Scenario 1: An electronic acquisition unit is connected to a traditional ferromagnetic voltage transformer, the traditional ferromagnetic voltage transformer outputs a standard 100V analog signal, the electronic acquisition unit is integrated in the form of a plug-in card into a merging unit chassis, the electronic acquisition unit conditions a voltage signal output from the ferromagnetic voltage transformer and then transmits a conditioned signal through a chassis back plate to a merging unit AD sampling loop for digital conversion, and an application circuit diagram is shown in FIG. 1.

Scenario 2: The electronic acquisition unit is connected to an electronic voltage transformer with a resistive divider, capacitive divider, or resistive-capacitive divider, an input signal is a voltage analog quantity, the electronic acquisition unit is an independently packaged module, which performs digital conversion on the analog voltage signal output from the electronic voltage transformer and outputs a digital FT3 signal, and then sends a digital voltage measurement digital quantity to the merging unit, and an application circuit diagram is shown in FIG. 2.

Principles of the electronic acquisition unit of the voltage transformer cover basic technical principles currently used in the industry. This mode is primarily used for measuring power frequency signals, and the output voltage acquisition FT3 signal mode is single, making it unsuitable for wide-band voltage measurement.

## SUMMARY

The present invention is intended to provide a multi-channel electronic acquisition unit connected to a wide-band voltage transformer, to resolve a problem that a signal is output by an electronic acquisition unit in a single mode in the prior art, which is not suitable for wide-band voltage measurement.

To resolve the above technical problem, the present invention provides a multi-channel electronic acquisition unit connected to a wide-band voltage transformer, including a conditioning loop module and an analog-to-digital conversion module, where the conditioning loop module includes at least two conditioning branches, input terminals of all conditioning branches are connected and connected to an input terminal of the conditioning loop module through an initial conditioning circuit, the initial conditioning circuit is configured to perform common-mode suppression and signal amplification on an analog signal input by the electronic acquisition unit, output terminals of all conditioning branches are respectively connected to corresponding different output terminals of the conditioning loop module, and an amplitude conditioning circuit and a filter conditioning circuit are arranged on each conditioning branch in series, where at least one output terminal of the conditioning loop module is connected to an input terminal of the analog-to-digital conversion module and is configured to convert a conditioned analog signal into a digital signal, and at least one of remaining output terminals of the conditioning loop module is directly connected to an analog output port on the electronic acquisition unit.

Beneficial effects are as follows: the present invention improves the conditioning loop in the electronic acquisition unit to resolve the problem that a signal is output by the electronic acquisition unit in a single mode in the prior art, and an output signal communicates with only the merging unit, which is not suitable for wide-band voltage measurement, so that data collected by the voltage transformer is conditioned by the conditioning loop, and then at least two analog signals are output. At least one analog signal is converted into a digital signal, and the digital signal is output from the electronic acquisition unit, and at least one of remaining analog signals is directly output from the electronic acquisition unit, to implement acquisition of high-order voltage harmonics and transmission of analog and digital signals, ensuring the safe and stable operation of a power grid, providing accurate measurement of a power-frequency signal, a harmonic signal, and a transient signal, promoting the upgrading of the voltage transformer, building a new generation of digital full-frequency domain sensing and application system, and improving an overall perception and application level of a new power system.

Further, the amplitude conditioning circuit is in a proportional reduction mode.

Beneficial effects are as follows: an amplitude of an analog signal output by the wide-band voltage transformer is amplified by adjusting a primary voltage division ratio of the wide-band voltage transformer, or amplified by differential conditioning, and the analog amplitude is reduced in the proportional reduction mode, so that the amplitude is increased or decreased based on the demands, to obtain an analog quantity of a required amplitude value.

Further, the proportional reduction mode is a resistance amplitude modulation mode.

Beneficial effects are as follows: considering characteristics of fast transient transfer, a resistance amplitude modulation mode is used to make an amplitude modulation speed faster.

Further, the initial conditioning circuit is a differential amplification circuit.

Further, the differential amplification circuit and the filter conditioning circuit are both implemented based on an operational amplifier.

Beneficial effects are as follows: the differential amplification circuit and the filter conditioning circuit are conditioned by the operational amplifier, so that the conditioning circuit performs conditioning simply and stably.

Further, an amplitude range expression of the analog signal output from the analog output port is as follows:

$$|x \cdot K1 \cdot K2| < |ax| < |Y1|$$

$$|ax| = |y1|$$

where x is an analog voltage signal output by the wide-band voltage transformer; a is a maximum amplification of a primary voltage amplitude range under a lightning voltage; K1 is a magnification of a differential amplification circuit; K2 is an amplification of an amplitude conditioning circuit on a corresponding conditioning branch; Y1 is a range of an allowable access amplitude for an external access device at the analog output port; and y1 is an amplitude of an analog signal output by the analog output port.

Beneficial effects are as follows: the electronic acquisition unit meets the requirements of the technical index, the amplification circuit in the conditioning branch that outputs the analog signal is limited, and a final analog signal output by the analog output port meets the requirements.

Further, an amplitude range expression of the digital signal output by the electronic acquisition unit is as follows:

$$|x \cdot K1 \cdot K3| < |ax| < |Y2|$$

$$|ax| = |y2|$$

where x is an analog voltage signal output by the wide-band voltage transformer; a is a maximum amplification of a primary voltage amplitude range under a lightning voltage; K1 is a magnification of a differential amplification circuit; K3 is a magnification of an amplitude conditioning circuit on a corresponding conditioning branch; Y2 is a range of an allowable access amplitude of a digital signal output by the electronic acquisition unit for an external access device; and y2 is an amplitude of an analog signal output by the electronic acquisition unit.

Beneficial effects are as follows: the electronic acquisition unit meets the requirements of the technical index, the amplification circuit in the conditioning branch that outputs the digital signal is limited, and a final analog signal output by the electronic acquisition unit meets the requirements.

Further, a formula for a sampling rate of the analog-to-digital conversion module is as follows:

$$N_s = bf_{max}$$

where $N_s$ is the sampling rate; $f_{max}$ is a maximum frequency measured, and b is a frequency coefficient.

Further, the operational amplifier obtains a gain bandwidth BGP>70M and a slew rate SR>2,000 V/μs based on technical indicators satisfied by the electronic acquisition unit.

Further, the electronic acquisition unit further includes a metal shielding cap for accommodating the analog output port, to perform protection and electromagnetic field shielding on the analog output port.

Beneficial effects are as follows: when the analog output port is not in use, the metal shielding cap can shield the influence of an electromagnetic field on the analog output port and play a role in mechanical protection.

**BRIEF DESCRIPTION OF THE DRAWINGS**

FIG. 1 is a schematic diagram of an electronic acquisition unit connected to a traditional ferromagnetic voltage transformer in the prior art;
FIG. 2 is a schematic diagram of the electronic acquisition unit connected to an electronic voltage transformer in the prior art;
FIG. 3 is a schematic diagram of the electronic acquisition unit according to the present invention;
FIG. 4 is a schematic diagram of a conditioning loop in the electronic acquisition unit according to the present invention;
FIG. 5 is a schematic diagram of amplitude conditioning in the conditioning loop in the electronic acquisition unit according to the present invention;
FIG. 6 is a schematic structural diagram of a terminal that outputs an analog voltage signal of the electronic acquisition unit according to the present invention;
FIG. 7 is a schematic circuit diagram of a differential conditioning circuit according to the present invention; and
FIG. 8 is a schematic circuit diagram of a filter conditioning circuit according to the present invention.

1-power module; 2-conditioning loop module; 3-high-speed AD module; 4-FPGA module; 5-optical port driver module; 6-wide-band VT; 7-serial port debug; 8-electronic acquisition unit housing; 9-output port; 10-second amplitude conditioning circuit; 11-first filter conditioning circuit; 12-second filter conditioning circuit; 13-differential conditioning circuit; 14-first amplitude conditioning circuit; 15-shielding aviation terminal; 16-metal shielding cap.

## DESCRIPTION OF THE EMBODIMENTS

A basic idea of the present invention is as follows: a conditioning loop in an electronic acquisition unit is improved, so that data collected by a voltage transformer is conditioned by the conditioning loop to output at least two analog voltage signals, where at least one analog voltage signal is directly output through an analog output terminal disposed for the electronic acquisition unit, and at least one of remaining analog voltage signals is converted to become a voltage acquisition FT3 signal to be output, so that the electronic acquisition unit can output both an analog signal and a digital signal. Based on the idea, a multi-channel electronic acquisition unit connected to a wide-band voltage transformer of the present invention can be implemented.

The present invention is described in detail below with reference to accompanying drawings and method embodiments.

Embodiments of the multi-channel electronic acquisition unit connected to the wide-band voltage transformer

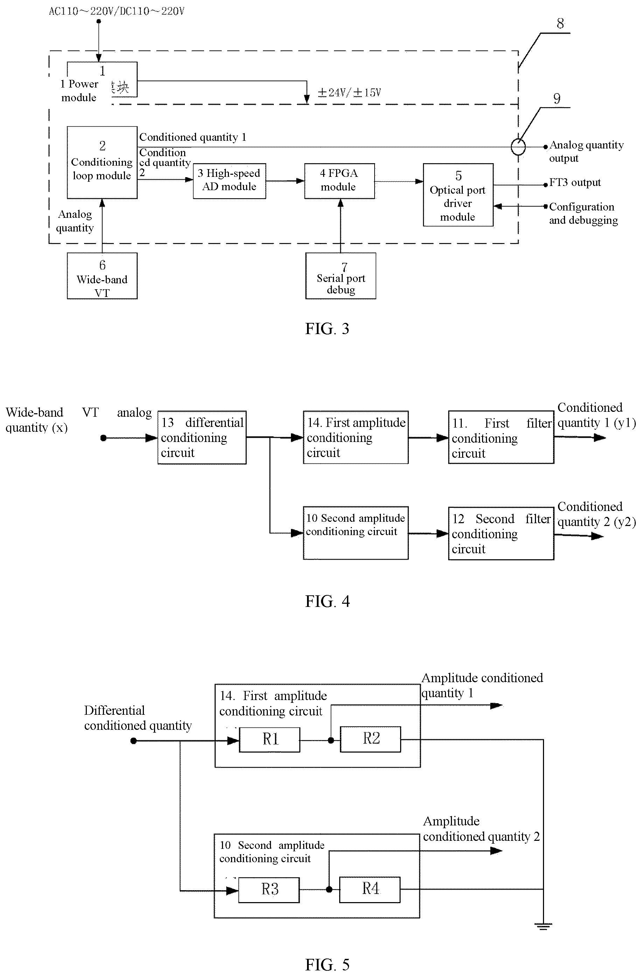

A schematic diagram of the multi-channel electronic acquisition unit connected to the wide-band voltage transformer of the present invention is shown in FIG. 3, including a power module 1, a conditioning loop module 2, a high-speed AD module 3, an FPGA module 4, an optical port driver module 5, an electronic acquisition unit housing 8, and an output port 9 (analog voltage signal output terminal). The power module is configured to convert external AC or DC power to supply power to the electronic acquisition unit. The conditioning loop module is configured to condition an analog voltage signal output by a wide band TV6 (wide-band voltage transformer) to obtain two analog voltage signals after conditioning. The high-speed AD module is configured to convert one of the analog voltage signals output by the conditioning loop module into a digital voltage signal. The FPGA module is configured to control the electronic acquisition unit and convert the digital voltage signal output by the high-speed AD module into an FT3 level protocol signal. The optical port driver module is configured to convert the FT3 level protocol signal output by the FPGA module into an FT3 optical pulse signal. The electronic acquisition unit housing is made of metal, and single point grounding is used during application to achieve electromagnetic field shielding and mechanical protection. The analog voltage signal output terminal is configured to output another analog voltage signal output by the conditioning loop module.

The electronic acquisition unit needs to be applicable the following technical indicators: 0.5 times to 5 times a rated primary voltage amplitude, a lightning impulse voltage of 1.2/50 $\mu$s, measurement amplitude deviation within 10%, and a wavefront response time error within 10%; a voltage measurement bandwidth not less than -3 dB under 50 Hz-1 MHz; harmonic voltage measurement amplitude deviation within 5% under 20 kHz and below.

Specific working steps of the electronic acquisition unit include the following steps.

(1) The conditioning loop module conditions the analog voltage signal output by the wide-band voltage transformer, as shown in FIG. 4, and the conditioning loop module includes differential conditioning (namely, a suppression and amplification module), amplitude conditioning, and filter conditioning, and a specific working mode is as follows:
the conditioning loop module first performs differential conditioning on the analog voltage signal (x) output by the wide-band voltage transformer, namely, performs common mode suppression and signal preliminary conditioning and amplification (with an amplification factor of K1), and a signal obtained after differential conditioning is transmitted as two signals, respectively, a conditioned quantity 1 (y1) output by a first conditioning branch and a conditioned quantity 2 (y2) output by a second conditioning branch, each conditioning branch is provided with amplitude conditioning and filter conditioning, a first amplitude conditioning circuit 14 and a first filter conditioning circuit 11 are arranged in series on the first conditioning branch, and a second amplitude conditioning circuit 10 and a second filtering conditioning circuit 12 are arranged in series on a second conditioning branch. The filtering conditioning is reflected as follows: a very fast front overvoltage (VFFO) is superimposed on an operating voltage of a device, which has a wide spectrum and a potentially faster rise time; and a system operating voltage is used as a reference when the VFFO is determined, and this fastest transition often has a high frequency component of up to 100 MHz. According to the technical solution, a goal of "a voltage measurement bandwidth not less than -3dB under 50 Hz-1 MHz" is designed, and the filter conditioning loop mainly performs filtering on transient voltage signals above 1 MHz of the very fast front overvoltage (VFFO). Because an amplitude of the analog voltage signal output by the wide-band voltage transformer can be amplified by adjusting a one-time differential voltage ratio of the wide-band voltage transformer or by differential conditioning, amplitude conditioning on two conditioning branches is designed in a proportional amplitude reduction mode. In consideration with characteristics of fast transient transfer, a resistance amplitude modulation mode is used, as shown in FIG. 5. Amplitude conditioning formulas for the two conditioning branches are as follows:

$$K2 = \frac{R2}{(R1 + R2)}$$

$$K3 = \frac{R4}{(R3 + R4)}$$

In the above equation, K2 is a magnification of the first amplitude conditioning circuit; R1 and R2 are resistance amplitude modulation values of the first amplitude conditioning circuit, respectively; K3 is a magnification of the second amplitude conditioning circuit; and R3 and R4 are resistance amplitude modulation values in the second amplitude conditioning circuit, respectively.

Based on technical indicators to be applied to the electronic acquisition unit, an amplitude range of a primary voltage under a lightning voltage is up to 5 times, and an amplitude conditioning range formula of the conditioned quantity 1 is as follows:

$$|x \cdot K1 \cdot K2| < |5x| < |Y1|$$

$$|5x| = |y1|$$

In the above formula, x is the analog voltage signal output by the wide-band voltage transformer; K1 is an amplification of the differential conditioning circuit; y1 is an amplitude of the conditioned quantity 1 output by the first conditioning branch; and $\pm Y1$ is a range of an allowable access amplitude of the conditioned quantity 1 for an external access device.

A formula for an amplitude conditioning range of the conditioned quantity 1 is as follows:

$$|x \cdot K1 \cdot K3| < |5x| < |Y2|$$

$$|5x| = |y2|$$

In the above formula, y2 is an amplitude of the conditioned quantity 2 output by the second conditioning branch; and Y2 is a range of an allowable access amplitude of the conditioned quantity 2 for an external access high-speed AD.

The first filter conditioning circuit, the second filter conditioning circuit, and the differential conditioning circuit are all implemented based on an operational amplifier, and key technical indicators that the operational amplifier satisfies include a gain bandwidth BGP>5 MHz and a slew rate SR>60V/μs. Bandwidths of the first filter conditioning and the second filter conditioning are both above 1 MHz, with 5 times overload considered, that is, BGP> 1 MHz×5=5 MHz, SR>60V/μs/1,000=0.06 V/ns. For example, under rated conditions, an output analog of the wide-band voltage transformer is 4V, an input analog rises by 5 times to be 20V, and 333ns are required, to ensure the bandwidth with a fast rise time, that is, the bandwidth fup=0.35/333 ns=1.05 MHz, then the bandwidth is approximately 1 MHz in a design range.

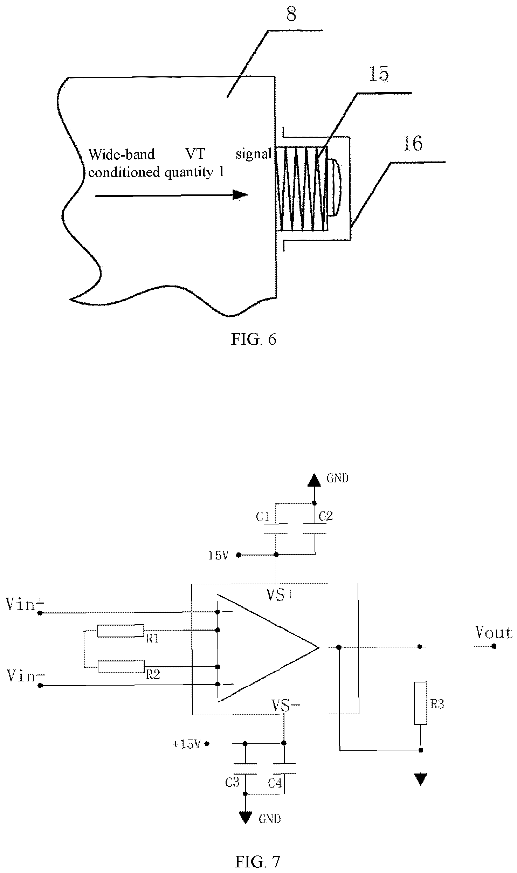

A schematic circuit diagram of the differential conditioning circuit is shown in FIG. 7, and

$$Vout = Vin \times \left(1 + \frac{19.8k}{R1+R2}\right)$$

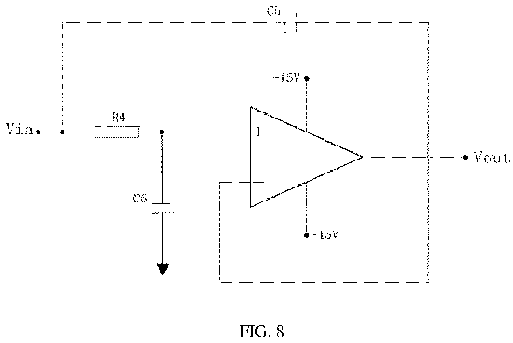

. The first filter conditioning circuit and the second filter conditioning circuit are shown in FIG. 8.

(2) The first conditioning branch outputs the conditioned quantity 1 through an output port from a shielding aviation terminal 15 to a high-speed oscilloscope or a high-speed sampling electronic circuit outside the electronic acquisition unit, and a metal shielding cap 16 is also installed outside the analog voltage signal output terminal, the metal shielding cap 16 and the shielding aviation terminal 15 are split structures, and the metal shielding cap 16 is in a threaded rotary packaging mode, which is used for implementing shielding and mechanical protection of an electromagnetic field, as shown in FIG. 6.

The second conditioning branch outputs the conditioned quantity 2 into a high-speed AD module, and the high-speed AD module collects a high-speed voltage of the conditioned quantity 2, to convert the conditioned quantity 2 of the analog quantity into a digital quantity, and a sampling rate value formula is as follows:

$$N_s = 4 \cdot f_{max}$$

In the above formula, $N_s$ is a sampling rate; $f_{max}$ is a maximum frequency measured.

Based on technical specifications that the electronic acquisition unit needs to apply, a voltage measurement bandwidth is 50 Hz-1 MHz. Therefore, a high-speed AD sampling rate is not less than 4 MHz.

(3) The FPGA module accesses the digital signal output by the high-speed AD module, and controls the electronic acquisition unit to convert the digital signal into an FT3 level protocol signal; and the FPGA module configures a program for itself through a serial port debug 7, to implement a control function of a host computer.

(4) The optical port driver module connects the FT3 level protocol signal output by the FPGA module, and converts the FT3 level protocol signal into an FT3 optical pulse signal.

According to the present invention, the collection of higher-order voltage harmonics and the transmission of both analog and digital signals can be implemented, which is a key measure for ensuring the safe and stable operation of a power grid, which can simultaneously provide precise measurement of a power-frequency signal and accurate measurement of a harmonic signal and a transient signal. The present invention can promote the upgrading and replacement of voltage transformers, and is a key step in building a new generation of digitalized full-frequency domain sensing and application systems and improving the overall sensing and application capabilities of the new power system. This technology can be widely applied in AC substations with new energy access, which has a broad market prospect.

## Claims

1. A multi-channel electronic acquisition unit connected to a wide-band voltage transformer, comprising a conditioning loop module and an analog-to-digital conversion module, **characterized in that** the conditioning loop module comprises at least two conditioning branches, input terminals of all conditioning branches are connected and connected to an input terminal of the conditioning loop module through an initial conditioning circuit, the initial conditioning circuit is configured to perform common-mode suppression and signal amplification on an analog signal input by the electronic acquisition unit, output terminals of all conditioning branches are respectively connected to corresponding different output terminals of the conditioning loop module, and an amplitude conditioning circuit and a filter conditioning circuit are arranged on each conditioning branch in series, wherein at least one output terminal of the conditioning loop module is connected to an input terminal of the analog-to-digital conversion module and is configured to convert a conditioned analog signal into a digital signal, and at least one of remaining output terminals of the conditioning loop module is directly connected to an analog output port on the electronic acquisition unit.

2. The multi-channel electronic acquisition unit connected to a wide-band voltage transformer according to claim 1, **characterized in that** the amplitude conditioning circuit is in a proportional reduction mode.

3. The multi-channel electronic acquisition unit connected to a wide-band voltage transformer according to claim 2, **characterized in that** the proportional reduction mode is a resistance amplitude modulation mode.

4. The multi-channel electronic acquisition unit connected to a wide-band voltage transformer according to claim 1, **characterized in that** the initial conditioning circuit is a differential amplification circuit.

5. The multi-channel electronic acquisition unit connected to a wide-band voltage transformer according to claim 1, **characterized in that** both the differential amplification circuit and the filter conditioning circuit are implemented based on an operational amplifier.

6. The multi-channel electronic acquisition unit connected to a wide-band voltage transformer according to claim 1, **characterized in that** an amplitude range expression for an analog signal output by the analog output port is as follows:

$$|x \cdot K1 \cdot K2| < |ax| < |Y1|$$

$$|ax| = |y1|$$

wherein x is an analog voltage signal output by the wide-band voltage transformer; a is a maximum amplification of a primary voltage amplitude range under a lightning voltage; K1 is a magnification of a differential amplification circuit; K2 is an amplification of an amplitude conditioning circuit on a corresponding conditioning branch; Y1 is a range of an allowable access amplitude for an external access device at the analog output port; and y1 is an amplitude of an analog signal output by the analog output port.

7. The multi-channel electronic acquisition unit connected to a wide-band voltage transformer according to claim 1, **characterized in that** an amplitude range expression for a digital signal output by the electronic acquisition unit is as follows:

$$|x \cdot K1 \cdot K3| < |ax| < |Y2|$$

$$|ax| = |y2|$$

wherein x is an analog voltage signal output by the wide-band voltage transformer; a is a maximum amplification of a primary voltage amplitude range under a lightning voltage; K1 is a magnification of a differential amplification circuit; K3 is a magnification of an amplitude conditioning circuit on a corresponding conditioning branch; Y2 is a range of an allowable access amplitude of a digital signal output by the electronic acquisition unit for an external access device; and y2 is an amplitude of an analog signal output by the electronic acquisition unit.

8. The multi-channel electronic acquisition unit connected to a wide-band voltage transformer according to claim 1, **characterized in that** a formula for obtaining a value of a sampling rate of the analog-to-digital conversion module is as follows:

$$N_s = bf_{max}$$

wherein $N_s$ is the sampling rate; $f_{max}$ is a maximum frequency measured, and b is a frequency coefficient.

9. The multi-channel electronic acquisition unit connected to a wide-band voltage transformer according to claim 5, **characterized in that** the operational amplifier obtains a gain bandwidth BGP>70M and a slew rate SR>2,000 V/$\mu$s based on technical indicators satisfied by the electronic acquisition unit.

10. The multi-channel electronic acquisition unit connected to a wide-band voltage transformer according to claim 1, **characterized in that** the electronic acquisition unit further comprises a metal shielding cap for accommodating the analog output port, to perform protection and electromagnetic field shielding on the analog output port.

| Merging unit/Merging-smart terminal | | | |
|---|---|---|---|
| VT conversion loop | Sampling plug-in component | Digital processing loop | |
| Conditioning loop | AD | FPGA CPU | Optical port driver |

IEC 61850-9-1/2

Analog signal

Ferromagnetic VT

FIG. 1

DC220V/DC110V

Power supply

±24V/±15V

Conditioning loop

Conditioning signal

AD

FPGA

Optical port driver

FT3

Merging unit

Analog signal

Electronic VT

FIG. 2

AC110~220V/DC110~220V

8

| 1 |
| 1 Power module  块 |

±24V/±15V

9

| 2 Conditioning loop module |
Conditioned quantity 1
Condition ed quantity 2

● Analog quantity output

| 3 High-speed AD module | → | 4 FPGA module | → | 5 Optical port driver module |

● FT3 output
● Configuration and debugging

Analog quantity

| 6 Wide-band VT |

| 7 Serial port debug |

FIG. 3

Wide-band VT analog quantity (x)

| 13 differential conditioning circuit | → | 14. First amplitude conditioning circuit | → | 11. First filter conditioning circuit |

Conditioned quantity 1 (y1)

| 10 Second amplitude conditioning circuit | → | 12 Second filter conditioning circuit |

Conditioned quantity 2 (y2)

FIG. 4

Differential conditioned quantity

| 14. First amplitude conditioning circuit | R1 | R2 |

Amplitude conditioned quantity 1

| 10 Second amplitude conditioning circuit | R3 | R4 |

Amplitude conditioned quantity 2

FIG. 5

8

15

16

Wide-band VT signal
conditioned quantity 1

FIG. 6

GND

C1 C2

−15V

VS+

Vin+

R1

R2

Vin−

Vout

VS−

+15V

R3

C3 C4

GND

FIG. 7

FIG. 8

## INTERNATIONAL SEARCH REPORT

| International application No. |
| --- |
| **PCT/CN2024/130368** |

### A. CLASSIFICATION OF SUBJECT MATTER

H03M1/12(2006.01)i

According to International Patent Classification (IPC) or to both national classification and IPC

### B. FIELDS SEARCHED

Minimum documentation searched (classification system followed by classification symbols)

IPC: H03M

Documentation searched other than minimum documentation to the extent that such documents are included in the fields searched

Electronic data base consulted during the international search (name of data base and, where practicable, search terms used)

CNABS, CNTXT, VEN, EPTXT, WOTXT, CNKI, IEEE: 互感器, 调理, 差分放大, 滤波, 幅值, 支路, 数字, 模拟, 输出, transformer, conditioning, differential amplification, filter, amplitude, by-pass, digital, analog, output

### C. DOCUMENTS CONSIDERED TO BE RELEVANT

| Category* | Citation of document, with indication, where appropriate, of the relevant passages | Relevant to claim No. |
| --- | --- | --- |
| PX | CN 117879605 A (STATE GRID ZHEJIANG ELECTRIC POWER CO., LTD., JIAXING POWER SUPPLY COMPANY et al.) 12 April 2024 (2024-04-12) description, paragraphs [0006]-[0069] | 1-10 |
| A | CN 103323665 A (SHANGHAI DOUBLE X TECHNOLOGY CO., LTD.) 25 September 2013 (2013-09-25) description, paragraphs [0028]-[0033] | 1-10 |
| A | CN 109975603 A (INTEGRATED ELECTRONIC SYSTEMS LAB CO., LTD.) 05 July 2019 (2019-07-05) entire document | 1-10 |
| A | CN 204007861 U (CHINA THREE GORGES UNIVERSITY) 10 December 2014 (2014-12-10) entire document | 1-10 |
| A | CN 214201590 U (CHENGDU TECHNOLOGICAL UNIVERSITY) 14 September 2021 (2021-09-14) entire document | 1-10 |

☑ Further documents are listed in the continuation of Box C. ☑ See patent family annex.

| | |
| --- | --- |
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **12 December 2024** | **25 December 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2024/130368**

### C. DOCUMENTS CONSIDERED TO BE RELEVANT

| Category* | Citation of document, with indication, where appropriate, of the relevant passages | Relevant to claim No. |
|---|---|---|
| A | WO 2018032754 A1 (GUANGZHOU ZHIYUAN ELECTRONICS CO., LTD.) 22 February 2018 (2018-02-22) entire document | 1-10 |

Form PCT/ISA/210 (second sheet) (July 2022)

**INTERNATIONAL SEARCH REPORT**
Information on patent family members

International application No.

**PCT/CN2024/130368**

| Patent document cited in search report | | | Publication date (day/month/year) | Patent family member(s) | Publication date (day/month/year) |
|---|---|---|---|---|---|
| CN | 117879605 | A | 12 April 2024 | None | |
| CN | 103323665 | A | 25 September 2013 | None | |
| CN | 109975603 | A | 05 July 2019 | None | |
| CN | 204007861 | U | 10 December 2014 | None | |
| CN | 214201590 | U | 14 September 2021 | None | |
| WO | 2018032754 | A1 | 22 February 2018 | None | |

Form PCT/ISA/210 (patent family annex) (July 2022)